# EUROPÄISCHE PATENTSCHRIFT

(11) **EP 0 730 350 B1**
(45) Veröffentlichungstag und Bekanntmachung des Hinweises auf die Patenterteilung: **30.05.2001**
(21) Anmeldenummer: 95117024.0
(22) Anmeldetag: 28.10.1995
(51) Int. Cl.: H03K 17/18

(54) **Schaltung zum Ein- und Ausschalten einer elektrischen Last**
Circuit for turning on and off an electrical load
Montage pour la mise en circuit et hors circuit d'une charge électrique

(30) Priorität: 01.03.1995 DE 19507073
(43) Veröffentlichungstag der Anmeldung: 04.09.1996
(73) Patentinhaber: ROBERT BOSCH GMBH, 70442 Stuttgart (DE)
(72) Erfinder: Krieger, Klaus, D-73249 Wernau (DE); Boettigheimer, Andreas, D-72639 Neuffen (DE); Schmidt, Jürgen, D-73614 Schorndorf (DE)

(56) Entgegenhaltungen:
- EP-A- 0 011 680
- EP-A- 0 730 348
- EP-A- 0 730 349
- DE-A- 3 338 627
- DE-A- 4 413 194

## Beschreibung

### Stand der Technik

Die Erfindung geht aus von einer Schaltung zum Ein- und Ausschalten einer elektrischen Last nach der Gattung des unabhängigen Anspruchs. Aus der EP-A 11 680 ist eine in einem Airbag-Steuergerät enthaltene Endstufenschaltung bekannt, die aus Sicherheitsgründen zwei in Reihe mit der Last geschaltete Schalttransistoren aufweist. Als Last ist ein Heizelement vorgesehen, das eine Treibladung zum Aufblasen des Airbags thermisch zündet. Die Endstufentransistoren werden von Schaltsignalen zum Ein- und Ausschalten der Halbleiterschalter beaufschlagt, die von einer Steuerschaltung bereitgestellt sind. Die Steuerschaltung erzeugt die Schaltsignale in Abhängigkeit von der an einem Beschleunigungssensor auftretenden Spannung sowie in Abhängigkeit von Signalen, die von Komparatoren bereitgestellt werden, welche die an den Endstufentransistoren vorliegenden Potentialverhältnisse erfassen. Die Steuerschaltung sieht eine getrennte Bereitstellung der Schaltsignale für die Endstufentransistoren vor, wobei die verwendeten logischen Bauelemente in einer integrierten Schaltung enthalten sein können.

Der Erfindung liegt die Aufgabe zugrunde, eine Schaltung zum zuverlässigen Ein- und Ausschalten einer elektrischen Last anzugeben.

Die Aufgabe wird durch die im Hauptanspruch angegebenen Merkmale gelöst.

### Vorteile der Erfindung

Die erfindungsgemäße Schaltung sieht zunächst vor, daß in Reihe mit der Last ein erster Halbleiterschalter oder eine erste Halbleiterschaltergruppe sowie wenigstens ein zweiter Halbleiterschalter oder wenigstens eine zweite Halbleiterschaltergruppe geschaltet sind. Eine Steuerschaltung erzeugt für die beiden Halbleiterschalter Steuersignale zum Ein- und Ausschalten. Die Steuerschaltung ist beispielsweise in einem Mikroprozessor enthalten, der die Steuersignale an zwei Output-Ports zur Verfügung stellt. Die Steuerschaltung gibt für den zweiten Halbleiterschalter unmittelbar das zweite Steuersignal vor. Erfindungsgemäß ist ein von der Steuerschaltung unabhängiger Invertierer vorgesehen, der das von der Steuerschaltung für den ersten Halbleiterschalter vorgesehene Steuersignal invertiert. Die erfindungsgemäße Schaltung erhöht dadurch die Sicherheit, daß bei einem Defekt der Steuerschaltung, bei dem beide Steuersignale einem Einschaltsignal entsprechen würden, die Last dennoch abgeschaltet bleibt. Der erfindungsgemäß vorgesehene Invertierer ist eine von der Steuerschaltung unabhängige Baugruppe, beispielsweise ein separater integrierter Schaltkreis, der außerhalb des die Steuerschaltung bildenden Mikroprozessors angeordnet ist.

Vorteilhafte Ausgestaltungen und Weiterbildungen der erfindungsgemäßen Schaltung ergeben sich aus abhängigen Ansprüchen.

Eine weitere Erhöhung der Sicherheit ergibt sich dadurch, daß die verwendeten Halbleiterschalter unterschiedliche Eigenschaften aufweisen. Mechanische, elektrische und insbesondere thermische Einflüsse wirken sich auf die wenigstens zwei Halbleiterschalter dann unterschiedlich aus. Ein gleichzeitiger Ausfall sämtlicher Halbleiterschalter ist daher unwahrscheinlicher als der Ausfall lediglich eines Halbleiterschalters. Unterschiedliche Eigenschaften der Halbleiterschalter werden erreicht, wenn unterschiedliche Typen der gleichen Baureihe verwendet werden. Unterschiede zwischen den einzelnen Typen einer Baureihe liegen beispielsweise in der Spannungsfestigkeit oder beispielsweise im Stromverstärkungsfaktor vor. Auch unterschiedliche Bauformen der einzelnen Halbleiterschalter führen zu unterschiedlichen Eigenschaften. Insbesondere ergeben sich Abweichungen bei dem thermischen Verhalten. Eine weitere Möglichkeit, Halbleiterschalter mit unterschiedlichen Eigenschaften zu erhalten, bietet der Einsatz von Halbleiterschaltern, denen unterschiedliche Wirkungsprinzipien zugrundeliegen. Die Eigenschaften von beispielsweise Bipolartransistoren, Feldeffekttransistoren oder Thyristoren weichen erheblich voneinander ab.

Eine andere vorteilhafte Weiterbildung sieht vor, daß die an der Last abfallende Spannung in einem Komparator mit einem Schwellenwert verglichen wird. Der Komparator gibt ein Signal ab, das den Einschaltzustand der Last anzeigt. Dieses Signal ermöglicht eine Überprüfung der Halbleiterschalter.

Eine erste Überprüfungsmöglichkeit der Halbleiterschalter sieht die Verwendung eines Vergleichers vor, der eine der Steuerschaltung zugeführte externe Einschaltvorgabe mit dem Einschaltzustand der Last vergleicht. Bei Abweichungen wird beispielsweise ein Warnsignal ausgelöst und sichergestellt, daß ein Einschalten der Last nicht mehr möglich ist.

Eine andere vorteilhafte Weiterbildung sieht den Einsatz einer Auswahlschaltung vor, die, unabhängig von der externen Einschaltvorgabe, die Veranlassung von Steuersignalen für die Halbleiterschalter vorsieht, die entweder Ein- oder Ausschaltsignalen entsprechen. Die Auswahlschaltung ermöglicht somit eine Überprüfung der Last und/oder der Endstufe sowohl bei ausgeschalteter als auch bei eingeschalteter Last. Wenn beispielsweise die externe Einschaltvorgabe nicht vorliegt, kann mit der Auswahlschaltung der eine und der andere Halbleiterschalter eingeschaltet werden. Liegt dennoch ein vom ersten Vergleicher festgestellter Einschaltzustand der Last vor, so kann der Halbleiterschalter angezeigt werden, der defekt ist. Wenn beispielsweise die externe Einschaltvorgabe vorliegt, kann die Auswahlschaltung den einen Halbleiterschalter und den anderen Halbleiterschalter abschalten. Wieder ist eine Überprüfung der Halbleiterschalter mit dem vom Komparator abgegebenen Signal möglich.

Eine vorteilhafte Ausgestaltung sieht vor, daß die Auswahlschaltung unterscheidet zwischen einer ersten und einer zweiten Zeitdauer der bereitgestellten Schaltsignale zum Ein- oder Ausschalten der Last. Die kürzere Zeitdauer ist derart festzulegen, daß der die Last enthaltende elektrische Verbraucher von einem kurzzeitigen Einschalten oder Ausschalten nicht weiter beeinflußt ist. Die Vorgabemöglichkeit einer zweiten Zeitdauer, die länger ist als die erste Zeitdauer, ermöglicht neben der Überprüfung der Halbleiterschalter auch eine Überprüfung der Last mittels eines vom Verbraucher bereitgestellten Verbraucheraktivitätssignals. Die zweite Zeitdauer ist demnach derart festzulegen, daß das
Verbraucheraktivitätssignal seinen Zustand ändern kann. Damit ist beispielsweise ein Abschalttest realisierbar.

Die erfindungsgemäße Schaltung ist insbesondere geeignet zum Ein- und Ausschalten eines Magnetventils als elektrische Last. Das Magnetventil ist vorzugsweise in einem öl- cder gasbetriebenen Heizgerät eingesetzt. In dieser Anwendung ist die ordnungsgemäße Funktion der Halbleiterschalter sowie des Magnetventils von besonderer Wichtigkeit.

Die erfindungsgemäße Schaltung kann in der Anwendung bei einem Heizgerät in mehrfacher Ausfertigung enthalten sein. Aus Sicherheitsgründen ist beispielsweise eine Serienschaltung von zwei Magnetventilen vorgesehen, die jeweils mit der erfindungsgemäßen Schaltung ein- und ausgeschaltet werden. Die beschriebenen Sicherheitskonzepte, die sich auf eine Schaltung bezogen haben, können vorteilhafter Weise die weiteren Schaltungen einbeziehen.

Weitere vorteilhafte Weiterbildungen und Ausgestaltungen der erfindungsgemäßen Schaltung zum Ein- und Ausschalten einer elektrischen Last ergeben sich aus weiteren abhängigen Ansprüchen und aus der folgenden Beschreibung.

### Zeichnung

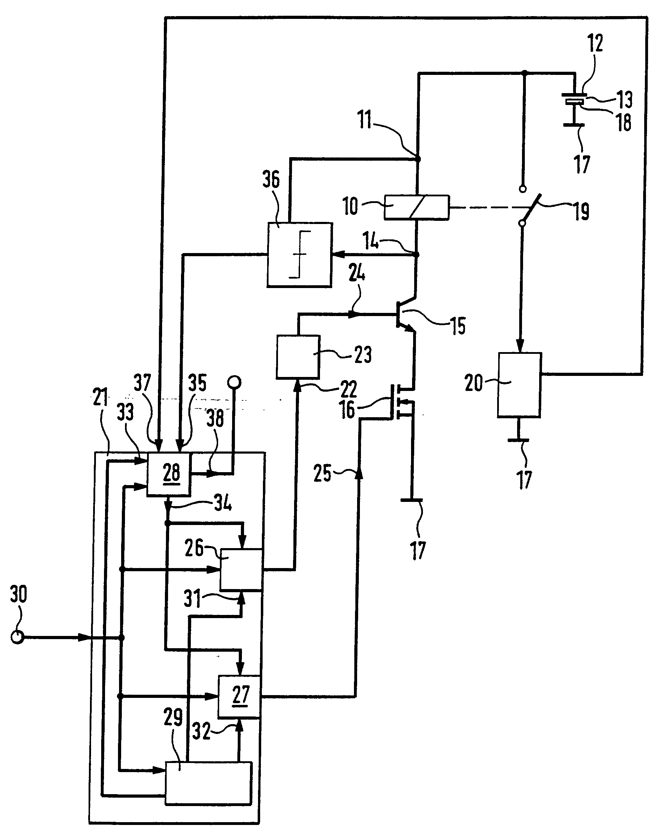

Die Figur zeigt ein Blockschaltbild einer erfindungsgemäßen Schaltung zum Ein- und Ausschalten einer elektrischen Last.

Die Figur zeigt eine elektrische Last 10, deren erster Anschluß 11 mit einem ersten Anschluß 12 einer Energiequelle 13 verbunden ist. Ein zweiter Anschluß 14 der Last 10 ist mit einem ersten Halbleiterschalter 15 verbunden, der in Reihe geschaltet ist mit einem zweiten Halbleiterschalter 16. Der zweite Halbleiterschalter 16 ist mit einer Masse 17 verbunden, an der auch ein zweiter Anschluß 18 der Energiequelle 13 angeschlossen ist.
Die Last 10 löst eine Funktion 19 in einem Verbraucher 20 aus. Im gezeigten Ausführungsbeispiel entspricht die Funktion 19 einem Schaltvorgang, der den Verbraucher 20 mit der Energiequelle 13 verbindet.

Anstelle des ersten und des zweiten Halbleiterschalters 15, 16 kann eine erste Gruppe von Halbleiterschaltern 15 und eine zweite Gruppe von Halbleiterschaltern 16 vorgesehen sein. Der erste Halbleiterschalter 15 erhält ein von einer Steuerschaltung 21 bereitgestelltes erstes Steuersignal 22 zugeleitet, das ein Invertierer 23 in ein invertiertes Steuersignal 24 umsetzt. Ein zweites Steuersignal 25, das dem zweiten Halbleiterschalter 16 zugeführt ist, stellt die Steuerschaltung 21 unmittelbar bereit.

Die Steuerschaltung 21 enthält eine erste und zweite Treiberschaltung 26, 27, einen Vergleicher 28 sowie eine Auswahlschaltung 29. Den beiden Treiberschaltungen 26, 27, dem Vergleicher 28 und der Auswahlschaltung 29 sind ein externes Schaltsignal 30 zugeführt.

Die Auswahlschaltung 29 gibt an die erste Treiberschaltung 26 ein erstes Schaltsignal 31 und an die zweite Treiberschaltung 27 ein zweites Schaltsignal 32 ab. Weiterhin gibt die Auswahlschaltung 29 ein Statussignal 33 ab, das dem Vergleicher 28 zugeleitet ist.

Die erste Treiberschaltung 26 stellt das erste Steuersignal 22 und die zweite Treiberschaltung 27 das zweite Steuersignal 25 bereit.

Der Vergleicher 28 erzeugt ein Abschaltsignal 34, das den beiden Treiberschaltungen 26, 27 zugeleitet ist. Weiterhin gibt der Vergleicher 33 ein Alarmsignal 38 nach außen ab. Der Vergleicher erhält ein Einschaltzustandssignal 35 zugeführt, das ein Komparator 36 abgibt. Der Komparator 36 ist mit den beiden Anschlüssen 11, 14 der Last 10 verbunden und vergleicht die an der Last 10 auftretende Spannung mit einem vorgegebenen Schwellenwert.

Der Vergleicher 28 erhält weiterhin ein Verbraucheraktivitätssignal 37 zugeleitet, das der Verbraucher 20 bereitstellt.

Die erfindungsgemäße Schaltung zum Ein- und Ausschalten der Last 10 arbeitet folgendermaßen:

Die erfindungsgemäße Schaltung ist zum Ein- und Ausschalten der Last 10 vorgesehen. Die Reihenschaltung des ersten Halbleiterschalters 15 mit wenigstens dem zweiten Halbleiterschalter 16 erhöht erheblich die Sicherheit der Schaltung. Ein Defekt eines der beiden Halbleiterschalter 15, 16 hat noch nicht zur Folge, daß die Last 10 zwangsläufig eingeschaltet wird. Die erhöhte Sicherheit ist insbesondere bei der Auslösung von sicherheitsrelevanten Funktionen 19 durch die elektrische Last 10 erforderlich.

Anstelle der in der Figur gezeigten beiden Halbleiterschalter 15, 16 sind gegebenenfalls eine Gruppe von ersten Halbleiterschaltern 15 sowie gegebenenfalls wenigstens eine Gruppe von weiteren Halbleiterschaltern 16 vorgesehen. Die Halbleiterschalter 15 der ersten Gruppe werden vom invertierten Steuersignal 24 und die Halbleiterschalter 16 der zweiten Gruppe vom zweiten Steuersignal 25 angesteuert. Die Erhöhung der Anzahl von Halbleiterschaltern, die in Reihe geschaltet sind, weist den Vorteil einer weiteren Erhöhung der Sicherheit auf.

Erfindungsgemäß ist zur Erhöhung der Sicherheit der Invertierer 23 vorgesehen, der das erste Steuersignal 22 invertiert und als invertiertes Steuersignal 24 dem ersten Halbleiterschalter 15 zuführt. Wesentlich ist es, daß der Invertierer 23 ein unabhängiges Schaltungsteil von der Steuerschaltung 21 bildet. Die Steuerschaltung 21 ist vorzugsweise in einem Mikroprozessor oder einem anderen herstellerseitig programmierbaren logischen Bauelement realisiert. Sofern bei einem Defekt der Steuerschaltung 21 der Zustand auftreten kann, daß die beiden Treiberschaltungen 26, 27 Steuersignale 22, 25 mit gleichem Pegel abgeben, verhindert der Invertierer 23 zuverlässig ein fehlerhaftes Einschalten der Last 10.

Eine besonders vorteilhafte Maßnahme zur Erhöhung der Sicherheit sieht vor, daß der erste und zweite Halbleiterschalter 15, 16 unterschiedliche Eigenschaften aufweisen. Als Halbleiterschalter 15, 16 können beispielsweise Kleinsignal-Schalttransistoren gleicher Bauform vorgesehen sein. Unterschiedliche Eigenschaften weisen dann Transistoren mit unterschiedlichen Typenbezeichnungen in einer Baureihe auf. Diese Transistoren unterscheiden sich beispielsweise in der Spannungsfestigkeit oder beispielsweise im Stromverstärkungsfaktor.

Eine andere vorteilhafte Möglichkeit sieht vor, daß die Halbleiterschalter 15, 16 unterschiedliche Bauformen aufweisen. Unterschiedliche Bauformen weisen stets ein unterschiedliches thermisches Verhalten und somit unterschiedliche Eigenschaften auf.

Eine weitere Möglichkeit, unterschiedliche Eigenschaften der Halbleiterschalter 15, 16 vorzugeben, bietet die Zugrundelegung unterschiedlicher Wirkungsprinzipien des ersten Halbleiterschalters 15 gegenüber dem zweiten Halbleiterschalter 16. Beispielsweise ist der erste Halbleiterschalter ein Bipolartransistor, während der zweite Halbleiterschalter beispielsweise ein Feldeffekttransistor, vorzugsweise ein MOS-Feldeffekttransistor ist. Andere Wirkungsprinzipien sind gegeben beispielsweise bei Darlingtontransistoren, Thyristoren oder Zweiwegthyristoren (Triac), ein- und ausschaltbare Thyristoren usw.

Insbesondere geeignet ist eine Kombination von einem Bipolartransistor mit einem Feldeffekttransistor, vorzugsweise einem MOS-Feldeffekttransistor. Diese beiden Halbleiterbauelemente sind für die unterschiedlichsten Leistungsbereiche bei vergleichbaren Bauformen erhältlich.

### (Fortsetzung ursprüngliche Seite 10 der Beschreibung)

Die Schaltung gemäß einer besonderen Ausführungsart der Erfindung ermöglicht eine weitere Erhöhung der Betriebssicherheit durch das Auswerten des vom Komparator 36 bereitgestellten Einschaltzustandssignals 35, das dem Vergleicher 28 zugeführt ist. Der Komparator 36 vergleicht die an der Last 10 auftretende Spannung mit einem vorgegebenen Schwellenwert, der einem Einschaltzustand der Last 10 entspricht.

Eine erste Maßnahme sieht eine Plausibilitätskontrolle vor, der das Einschaltzustandssignal 35, das der Steuerschaltung 21 zugeführte externe Schaltsignal 30 sowie das Verbraucheraktivitätssignal 37 zugrundegelegt sind. Eine erste Plausibilitätskontrolle liefert der Vergleich des Einschaltzustandssignals 35 mit dem externen Schaltsignal 30. Bei dieser Plausibilitätskontrolle findet eine Überprüfung der Halbleiterschalter 15, 16 statt. Eine Überprüfung des ersten Halbleiterschalters 15 schließt eine Überprüfung des Invertierers 23 sowie der ersten Treiberschaltung 26 ein. Eine Überprüfung des zweiten Halbleiterschalters 16 schließt eine Überprüfung der zweiten Treiberschaltung 27 ein.

Ein fehlerhafter Zustand liegt vor, wenn bei einem externen Schaltsignal 30, das einem eingeschalteten Zustand der Last 10 entspricht, das Schaltzustandssignal 35 nicht auftritt oder wenn bei einem externen Schaltsignal 30, das dem ausgeschalteten Zustand der Last 10 entspricht, ein Einschaltzustandssignal 35 auftritt. Stellt der Vergleicher 28 durch den Signalvergleich fest, daß ein derartiger Fehler vorliegt, so veranlaßt der Vergleicher 28 die Ausgabe des Abschaltsignals 34 sowie gegebenenfalls die Ausgabe des Alarmsignals 38. Die Last 10 und der die Last 10 enthaltende Verbraucher 20 sind mit dieser Maßnahme in den sicheren abgeschalteten Zustand überführbar.

Eine andere Plausibilitätskontrolle bezieht den Verbraucher 20 ein. Der zweite Vergleicher 28 kann das Verbraucheraktivitätssignal 37 sowohl mit dem Einschaltzustandssignal 35 als auch mit dem externen Schaltsignal 30 vergleichen. Insbesondere aus einem Vergleich des Verbraucheraktivitätssignals 37 mit dem Einschaltzustandssignal 35 der Last 10 kann auf einen Defekt im Verbraucher 20 geschlossen werden. Ein Abschalten des Verbrauchers 20 bei einem festgestellten Einschaltzustandssignal 35 der Last 10 ist dann allerdings nicht möglich, da keine weitere Eingriffsmöglichkeiten in den Verbraucher 20 vorgesehen sind. Der Vergleicher 28 kann aber in jedem Fall das Alarmsignal 38 abgeben.

Eine besonders vorteilhafte weitere Möglichkeit der Funktionskontrolle bietet die Auswahlschaltung 29. Die Auswahlschaltung 29 ermöglicht über das erste oder zweite Schaltsignal 31, 32 sowohl ein Einschalten als auch ein Ausschalten entweder des ersten Halbleiterschalters 15 oder des zweiten Halbleiterschalters 16 oder gleichzeitig beider Halbleiterschalter 15, 16. Der wesentliche Vorteil liegt zum einen darin, daß die Auswahlschaltung 29 die Schaltsignale 31, 32 getrennt für die beiden Halbleiterschalter 15, 16 bereitstellen kann und zum anderen, daß die Bereitstellung der Schaltsignale 31, 32 unabhängig vom externen Schaltsignal 30 erfolgen kann. Es ist somit möglich, einen Halbleiterschalter 15, 16 ausfindig zu machen, der entweder ständig im leitenden Zustand ist oder der nicht mehr eingeschaltet werden kann.

Der wesentliche Vorteil, der durch die Auswahlschaltung 29 gegeben ist, liegt in der Möglichkeit der Plausibilitätskontrolle sowohl im abgeschalteten als auch insbesondere im eingeschalteten Zustand der Last 10. Sämtliche in Verbindung mit dem externen Schaltsignal 30 erwähnten Plausibilitätskontrollen sind mit der Auswahlschaltung 29 auf flexible Weise möglich. Das von der Auswahlschaltung 29 bereitgestellte Statussignal 33 liefert dem Vergleicher 28 stets die Information, welcher der Halbleiterschalter 15, 16 ein- oder ausgeschaltet ist. Insbesondere liefert das Statussignal 33 die Information, daß die Last 10 mit den Schaltsignalen 31, 32 eingeschaltet oder ausgeschaltet ist. Mit dem Alarmsignal 38, das gegebenenfalls ausgegeben wird, kann gleichzeitig angegeben werden, welcher Halbleiterschalter 15, 16 defekt ist.

Eine besonders vorteilhafte Maßnahme sieht vor, daß die Auswahlschaltung 29 die zeitliche Dauer der beiden Schaltsignale 31, 32 festlegen kann. Mit dieser Maßnahme können besondere Betriebszustände des Verbrauchers 20 berücksichtigt werden.

Die Festlegung auf eine erste kurze Zeitdauer ist vorzugsweise zur Überprüfung der Halbleiterschalter 15, 16 vorgesehen, die auf die bereits beschriebene Weise erfolgt. Die erste Zeitdauer ist auf einen Wert festzulegen, bei dem der Verbraucher 20 sowohl im abgeschalteten als auch im eingeschalteten Zustand unbeeinflußt bleibt. Ein solcher Verbraucher weist beispielsweise eine Verzögerungszeit zwischen dem Ein-/Ausschalten und dem daraus resultierenden Ein- oder Ausschaltzustand auf.

Die Festlegung auf eine zweite längere Zeit ist dagegen vorgesehen, um die Last 10 selbst überprüfen zu können. In Abhängigkeit von der Ausgestaltung der Last 10 kann ein Zustand auftreten, bei dem die Last 10 defekt ist, obwohl das Einschaltzustandssignal 35 nicht vorliegt. Ein solcher Zustand kann beispielsweise bei einem Relais oder beipielsweise bei einem Magnetventil auftreten, wobei die Magnetwicklung stromlos ist, aber die Relaiskontakte kleben oder das Magnetventil im geöffneten Zustand verklemmt ist. Gibt die Auswahlschaltung 29 die Abschaltsignale 31, 32 mit der längeren Zeitdauer aus, bei der eine Reaktion des Verbrauchers 20 feststellbar ist, kann aufgrund des Verbraucheraktivitätssignals 37 festgestellt werden, daß die Last 10 defekt ist, wobei aber das Einschaltzustandssignal 35 korrekt vorliegt.

Die erfindungsgemäße Schaltung eignet sich insbesondere zur Verwendung in sicherheitsrelevanten Verbrauchern 20, welche die Last 10 enthalten. Ein solcher Verbraucher 20 ist beispielsweise ein öl- oder insbesondere ein gasbetriebenes Heizgerät. Als Last 10 ist beispielsweise ein Magnetventil vorgesehen, das einen Gasfluß freigibt oder sperrt. Das Verbraucheraktivitätssignal 37 ist bei einem öl-- oder gasbetriebenen Heizgerät vorzugsweise ein Flammenüberwachungssignal.

In sicherheitsrelevanten Verbrauchern 20 kann die erfindungsgemäß vorgeschlagene Schaltung mehrfach vorhanden sein. Beispielsweise kann eine Reihenschaltung mit zwei Magnetventilen bei einem öl- oder gasbetriebenen Heizgerät vorgesehen sein. Die Diagnosemöglichkeiten können ohne weiteres über mehrere Lasten 10 erstreckt werden. Insbesondere ist es möglich, eine der mehreren vorhandenen Lasten 10 unter Einbeziehung des Verbraucheraktivitätssignals 37 als defekt zu erkennen, wenn eine Last 10 eingeschaltet ist und auf die andere Last 10 das beschriebene Vorgehen angewendet wird.

## Patentansprüche

1. Schaltung zum Ein- und Ausschalten einer elektrischen Last, mit wenigstens zwei in Reihe mit der Last (10) geschalteten Halbleiterschaltern (15,16) und mit einer Steuerschaltung (21), welche Steuersignale (22,25) für die Halbleiterschalter (15,16) bereitstellt, wobei die Steuerlogik der ersten und zweiten Halbleiterschalter die gleiche Polarität aufweist, dadurch gekennzeichnet, dass die Steuerschaltung (21) ein erstes Steuersignal (22) für den ersten Halbleiterschalter (15) abgibt, dass ein Invertierer (23), der ein unabhängiges Schaltungsteil von der Steuerschaltung (21) bildet, vorgesehen ist, der das erste Steuersignal (22) invertiert und als invertiertes Steuersignal (24) dem ersten Halbleiterschalter (15) zuführt, und dass die Steuerschaltung (21) ein zweites Steuersignal (25) abgibt, das dem zweiten Halbleiterschalter (16) unmittelbar zugeführt ist.

2. Schaltung nach Anspruch 1, dadurch gekennzeichnet, dass die Halbleiterschalter (15, 16) unterschiedliche Eigenschaften aufweisen.

3. Schaltung nach Anspruch 2, dadurch gekennzeichnet, dass innerhalb einer Halbleiterbaureihe unterschiedlich bezeichnete Typen als Halbleiterschalter (15, 16) eingesetzt sind.

4. Schaltung nach Anspruch 2, dadurch gekennzeichnet, dass die Halbleiterschalter unterschiedliche Bauformen aufweisen.

5. Schaltung nach Anspruch 2, dadurch gekennzeichnet, dass den Halbleiterschaltern (15, 16) unterschiedliche Wirkungsprinzipien zugrunde liegen.

6. Schaltung nach Anspruch 5, dadurch gekennzeichnet, dass ein erster Halbleiterschalter (15) ein Bipolartransistor und ein zweiter Halbleiterschalter (16) ein Feldeffekttransistor, vorzugsweise ein MOS-Feldeffekttransistor ist.

7. Schaltung nach Anspruch 1, dadurch gekennzeichnet, dass ein Komparator (36) vorgesehen ist, der die an der Last (10) auftretende Spannung mit einem vorgegebenen Schwellenwert vergleicht und der ein Signal (35) abgibt, das einen Einschaltzustand (35) der Last (10) anzeigt.

8. Schaltung nach Anspruch 1 und 7, dadurch gekennzeichnet, dass ein Vergleicher (28) vorgesehen ist, der das Einschaltzustandssignal (35) und/oder ein von einem Verbraucher (20), der die Last (10) enthält, bereitgestelltes Verbraucheraktivitätssignal (37) mit wenigstens einem weiteren Signal (30, 31, 32, 33) vergleicht.

9. Schaltung nach Anspruch 8, dadurch gekennzeichnet, dass als weiteres Signal ein der Steuerschaltung (21) zugeführtes externes Schaltsignal (30) vorgesehen ist.

10. Schaltung nach Anspruch 1 und 8, dadurch gekennzeichnet, dass eine Auswahlschaltung (29) vorgesehen ist, die unabhängig vom externen Schaltsignal (30) Schaltsignale (31, 32) abgibt, von denen die Steuersignale (22,25) abgeleitet werden, und dass die Auswahlschaltung (29) ein den von den Schaltsignalen (31, 32) vorgegebenen Zustand der Last (10) wiedergegebenes Statussignal (33) an den Vergleicher (28) abgibt.

11. Schaltung nach Anspruch 10, dadurch gekennzeichnet, dass die Auswahlschaltung (29) die Schaltsignale (31, 32) eine erste kürzere Zeit oder eine zweite längere Zeit ausgibt.

12. Schaltung nach Anspruch 1, dadurch gekennzeichnet, dass als Last (10) ein Magnetventil vorgesehen ist, das in einem öl- oder gasbetriebenen Heizgerät (20) angeordnet ist.

## Claims

1. Circuit for switching an electrical load on and off, having at least two semiconductor switches (15, 16) connected in series with the load (10), and having a control circuit (21) which provides control signals (22, 25) for the semiconductor switches (15, 16), with the control logic of the first and second semiconductor switches having the same polarity, characterized in that the control circuit (21) emits a first control signal (22) for the first semiconductor switch (15), in that an invertor (23) is provided which forms an independent circuit part of the control circuit (21), inverts the first control signal (22) and supplies it as an inverted control signal (24) to the first semiconductor switch (15), and in that the control circuit (21) emits a second control signal (25) which is supplied directly to the second semiconductor switch (16).

2. Circuit according to Claim 1, characterized in that the semiconductor switches (15, 16) have different characteristics.

3. Circuit according to Claim 2, characterized in that, within a semiconductor range, differently designated types are used as semiconductor switches (15, 16).

4. Circuit according to Claim 2, characterized in that the semiconductor switches have different physical forms.

5. Circuit according to Claim 2, characterized in that the semiconductor switches (15, 16) are based on different principles of operation.

6. Circuit according to Claim 5, characterized in that a first semiconductor switch (15) is a bipolar transistor, and a second semiconductor switch (16) is a field-effect transistor, preferably an MOS field-effect transistor..

7. Circuit according to Claim 1, characterized in that a comparator (36) is provided, which compares the voltage that occurs across the load (10) with a predetermined threshold value and which emits a signal (35) which indicates that the load (10) is switched on (35),

8. Circuit according to Claims 1 and 7, characterized in that a comparator (28) is provided, which compares the switched-on state signal (35) and/or a burden activity signal (37), which is provided by a burden (20) which contains the load (10), with at least one further signal (30, 31, 32, 33).

9. Circuit according to Claim 8, characterized in that an external switching signal (30) which is supplied to the control circuit (21) is provided as a further signal.

10. Circuit according to Claims 1 and 8, characterized in that a selection circuit (29) is provided which emits switching signals (31, 32) independently of the external switching signal (30), from which switching signals (31, 32) the control signals (22, 25) are derived, and in that the selection circuit (29) emits to the burden (28) a status signal (33) which reflects the status of the load (10) predetermined by the switching signals (31, 32).

11. Circuit according to Claim 10, characterized in that the selection circuit (29) emits the switching signals (31, 32) a first shorter time or a second longer time [lacuna].

12. Circuit according to Claim 1, characterized in that a solenoid valve is provided as the load (10) and is arranged in an oil- or gas-operated heater (20).

## Revendications

1. Circuit de commutation d'une charge électrique comportant au moins deux commutateurs semi-conducteurs (15, 16) branchés en série sur la charge (10) et un circuit de commande (21) fournissant des signaux de commande (22, 25) destinés aux commutateurs semi-conducteurs (15, 16), la logique de commande du premier et du second commutateurs semi-conducteurs ayant la même polarité,
caractérisé en ce que
• le circuit de commande (21) fournit un premier signal de commande (22) pour le premier commutateur semi-conducteur (15),
• un inverseur (23) qui constitue une partie de circuit indépendante du circuit de commande (21), inverse le premier signal de commande (22) et fournit ce signal comme signal de commande inversé (24) au premier commutateur semi-conducteur (15) et,
• le circuit de commande (21) fournit un second signal de commande (25) directement fourni au second commutateur semi-conducteur (16).

2. Circuit selon la revendication 1,
caractérisé en ce que les commutateurs semi-conducteurs (15, 16) ont des propriétés différentes.

3. Circuit selon la revendication 2,
caractérisé en ce que dans une série de semi-conducteurs, on utilise des types différents de commutateurs semi-conducteurs (15, 16).

4. Circuit selon la revendication 2,
caractérisé en ce que les commutateurs semi-conducteurs ont des constructions différentes.

5. Circuit selon la revendication 2,
caractérisé en ce que les commutateurs semi-conducteurs (15, 16) ont des principes de fonctionnement différents.

6. Circuit selon la revendication 5,
caractérisé en ce qu' un premier commutateur semi-conducteur (15) est un transistor bipolaire et un second commutateur semi-conducteur (16) un transistor à effet de champ de préférence un transistor MOS.

7. Circuit selon la revendication 1,
caractérisé en ce qu' un comparateur (36) compare la tension aux borne de la charge (10) à un seuil prédéterminé et fournit un signal (35) indiquant l'état de branchement (35) de la charge (10).

8. Circuit selon les revendications 1 à 7,
caractérisé en ce qu' un comparateur (28) reçoit le signal d'état de branchement (35) et/ou un signal d'activité de consommateur (37) fournis par le consommateur (20) qui comporte la charge (10), pour comparer à au moins un autre signal (30, 31, 32, 33).

9. Circuit selon la revendication 8,
caractérisé en ce que l'autre signal est un signal de commutation externe (30) fourni au circuit de commande (21).

10. Circuit selon les revendications 1 à 8,
caractérisé en ce qu'
• un circuit sélecteur (29) fournit indépendamment du signal de commutation externe (30) des signaux de commutation (31, 32) dont on déduit les signaux de commande (22, 25), et le circuit sélecteur (29) fournit au comparateur (28), un signal d'état (33) représentant l'état de la charge (10) prédéfini par les signaux de commutation (31, 32).

11. Circuit selon la revendication 10,
caractérisé en ce que le circuit sélecteur (29) émet les signaux de commutation (31, 32) pendant un premier temps court ou un second temps long.

12. Circuit selon la revendication 1,
caractérisé en ce que la charge (10) est une électrovanne équipant un appareil de chauffage au mazout ou au gaz (20).
